(19) **Europäisches Patentamt European Patent Office Office européen des brevets**

(11) **EP 3 590 190 B1**

(12) **FASCICULE DE BREVET EUROPEEN**

(45) Date de publication et mention de la délivrance du brevet:
**21.09.2022 Bulletin 2022/38**

(21) Numéro de dépôt: **18706757.4**

(22) Date de dépôt: **27.02.2018**

(51) Classification Internationale des Brevets (IPC):
**H03K 17/687** (2006.01)    **H03K 17/041** (2006.01)
**H02M 7/483** (2007.01)

(52) Classification Coopérative des Brevets (CPC):
**H03K 17/6874;** H02M 7/483; H03K 17/04106;
H03K 2017/6875

(86) Numéro de dépôt international:
**PCT/EP2018/054826**

(87) Numéro de publication internationale:
**WO 2018/158259 (07.09.2018 Gazette 2018/36)**

(54) **CELLULE DE COMMUTATION DE PUISSANCE ISOLEE**

TRENNSCHALTZELLE

POWER ISOLATING SWITCHING CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **02.03.2017  FR 1700205**

(43) Date de publication de la demande:
**08.01.2020  Bulletin 2020/02**

(73) Titulaires:
- **Thales**
  **92400 Courbevoie (FR)**
- **Commissariat à l'Énergie Atomique et aux Énergies Alternatives**
  **75015 Paris (FR)**
- **Université de Limoges**
  **87032 Limoges (FR)**

(72) Inventeurs:
- **JARDEL, Olivier**
  **91120 Palaiseau (FR)**
- **QUERE, Raymond**
  **19600 Saint Pantaleon de Larche (FR)**
- **PIOTROWICZ, Stéphane**
  **78114 Magny les Hameaux (FR)**

- **BOUYSSE, Philippe**
  **87260 Vicq-sur-Breuilh (FR)**
- **DELAGE, Sylvain**
  **91400 Orsay (FR)**
- **MARTIN, Audrey**
  **87570 Rilhac-Rancon (FR)**

(74) Mandataire: **Atout PI Laplace**
**Immeuble "Visium"**
**22, avenue Aristide Briand**
**94117 Arcueil Cedex (FR)**

(56) Documents cités:
**WO-A1-96/18240    FR-A1- 3 020 222**
**US-A- 5 514 996**

- **Zachary Stokes ET AL: "3.6V, 3A, 9m Load Switch with Reverse Current Protection and Optional Quick Output Discharge 6-DSBGA -40 to 105", ECN, 30 mai 2016 (2016-05-30), XP055440698, Rockaway Extrait de l'Internet: URL:http://www.ti.com/lit/an/slva730/slva730.pdf [extrait le 2018-01-15]**

**Description**

L'invention se situe dans le domaine technique des alimentations à découpage à haute fréquence, et plus précisément des alimentations de ce type lorsqu'elles sont réalisées sous la forme de circuits intégrés monolithiques hyperfréquence (en anglais, MMIC pour Monolithic Microwave Integrated Circuit, ou circuit intégré monolithique hyperfréquences). L'invention s'applique plus particulièrement à la réalisation d'alimentations à découpage pour modulateurs de polarisation dans le cas d'applications de gestion dynamique de la polarisation d'amplificateurs radio fréquence (RF).

La gestion dynamique de la polarisation des amplificateurs RF dans une chaîne d'émission, de manière à suivre les variations de l'enveloppe du signal à amplifier, est un enjeu majeur dans les systèmes de communications modernes, car elle permet de faire fonctionner les amplificateurs au point de fonctionnement maximisant les rendements électriques.

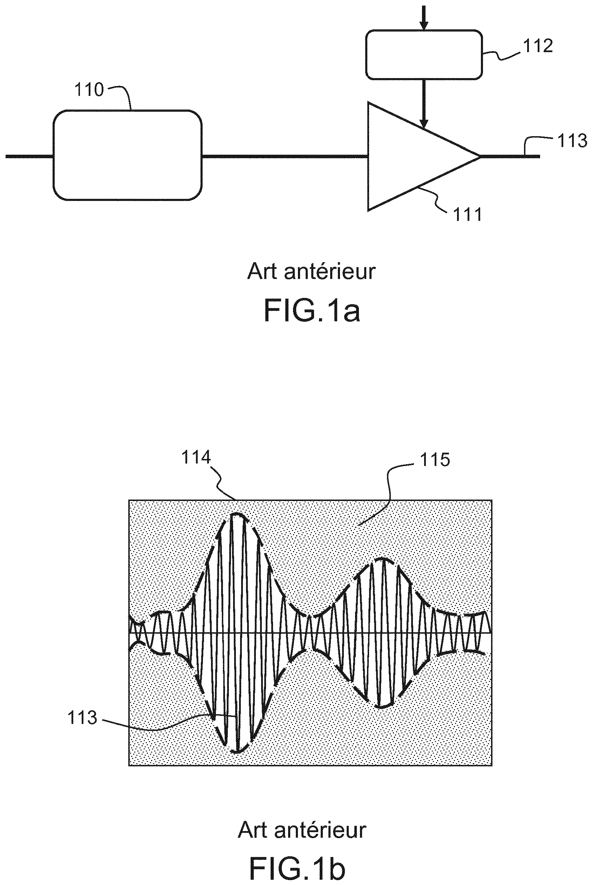

Les figures 1a à 1d illustrent les enjeux de cette gestion.

La figure 1a est une représentation simplifiée d'une chaîne d'émission dans un équipement standard. Un signal modulé en bande de base, dont l'amplitude varie au cours du temps, est transposé sur fréquence porteuse par une chaîne radio 110, puis amplifié par un amplificateur de puissance 111.

L'amplificateur 111 est alimenté/polarisé par un générateur 112 de tension continue, le signal émis est le signal 113.

La figure 1b illustre de façon simpliste le niveau du signal émis 113, ainsi que l'énergie dissipée par l'amplificateur. La tension de polarisation 112 de l'amplificateur étant continue, l'énergie 114 consommée par l'amplificateur est constante, et ceci indépendamment des variations de puissance du signal 113. Le niveau de la tension de polarisation de l'amplificateur est alors dimensionné par rapport au niveau maximum de puissance du signal à transmettre. Lorsque le niveau du signal émis n'atteint pas sa valeur maximum, la différence de puissance 115 est alors perdue et dissipée en chaleur, ce qui est synonyme de dépense inutile d'énergie et d'échauffement du composant.

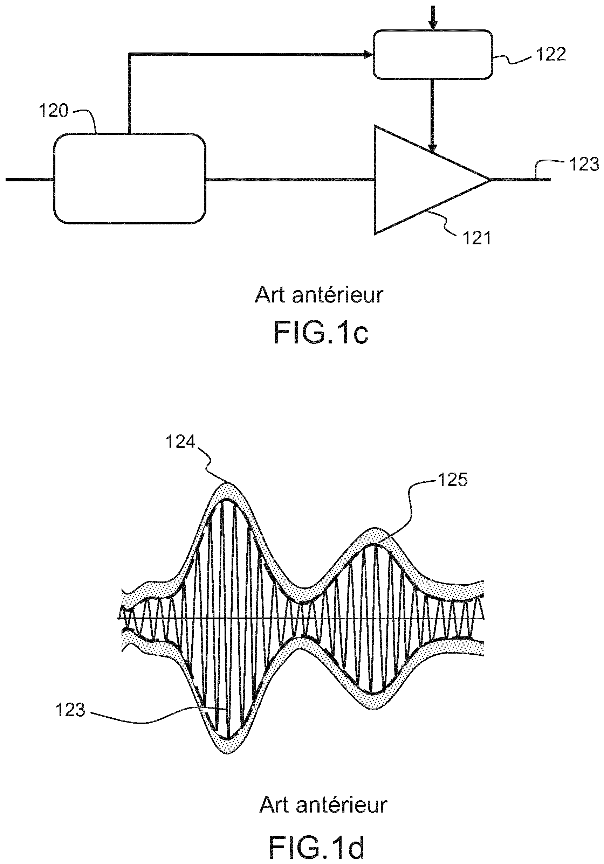

La figure 1c est une représentation simplifiée d'une chaîne d'émission dans un équipement configuré pour faire du suivi d'enveloppe d'un signal à transmettre.

Tout comme dans le cas présenté en figure 1a, le signal est modulé en bande de base puis transposé sur fréquence porteuse par une chaîne radio 120, et enfin amplifié par un amplificateur de puissance 121.

La différence avec la figure 1a est que le générateur 122 de tension de polarisation de l'amplificateur de puissance suit les variations de puissance du signal 123 transmis.

La figure 1d illustre les effets du pilotage de la tension de polarisation de l'amplificateur, dans le cas de l'émission d'un signal à amplitude non constante. Cette tension 124 varie de manière à suivre les variations du signal à transmettre 123. Ainsi, la puissance dissipée en chaleur 125 est réduite au minimum, ce qui permet d'économiser de l'énergie dans le dispositif d'émission.

Ces économies sont d'autant plus importantes que le niveau de puissance émise est grand, c'est pourquoi la gestion dynamique de la polarisation des amplificateurs est une solution d'intérêt en électronique hyperfréquences de puissance.

Des techniques de gestion dynamique de la tension de polarisation d'amplificateurs sont connues depuis plusieurs années, mais leur mise en œuvre n'est intervenue que récemment, principalement pour deux raisons :

- le développement des transistors en technologie GaN (Nitrure de Gallium) permet enfin d'envisager techniquement ces solutions,
- le développement de plus en plus important de systèmes de télécommunications sans fil, pour lesquels les architectures d'amplificateurs classiques ont des rendements électriques faibles, ont été l'objet d'efforts de recherche importants au vu des économies réalisables en termes de consommation électrique.

Les systèmes de gestion dynamique de polarisation sont constitués, entre autres, de modulateurs de tensions, eux-mêmes constitués d'une ou de plusieurs alimentations à découpage, dont la bande passante doit être au moins égale à celle de l'enveloppe des signaux RF à amplifier.

Un élément clé de ces alimentations à découpage réside dans la cellule de commutation de puissance, qui permet de commuter à sa sortie un signal de puissance en fonction d'un signal de commande de faible puissance appliqué à son entrée. Cette cellule doit satisfaire plus particulièrement à deux critères : rapidité de commutation et faible consommation électrique.

Pour réaliser une alimentation à découpage à partir de ces cellules de commutation, deux grandes familles de techniques sont connues:

- Les techniques dites de modulation de largeur d'impulsion (en anglais Pulse Width Modulation, ou PWM), qui consistent à moduler une tension d'alimentation par un signal logique dont la fréquence varie en fonction de la valeur de tension de sortie recherchée. Pour fonctionner de manière optimale, le signal logique doit avoir une fréquence au moins 5 ou 10 fois supérieure à la fréquence d'échantillonnage du signal à transmettre. Une seule cellule est alors requise. Le signal résultant de cette cellule est une suite de créneaux pour lesquels la tension vaut la tension initiale, ces créneaux étant plus ou moins larges en fonction de la tension de sortie recherchée. Le signal est alors filtré par un filtre passe bas, de manière à obtenir un signal dont le niveau est fonction de la largeur des créneaux. De nombreuses variantes de ces techniques de modulation de largeur d'impulsion existent, comme par exemple l'utilisation d'un signal logique triangulaire, ou la commande par hystérésis.

• Les techniques dites de commutateurs multi-niveaux, qui consistent à mettre en parallèle plusieurs cellules délivrant une tension de niveaux différents, chacune des cellules ayant un niveau de sortie distinct. La fréquence des commutations est alors moins grande que dans le cas précédent.

Les convertisseurs multi-niveaux ont l'avantage de réduire considérablement les besoins des cellules en vitesse de commutation, et n'imposent pas l'ajout d'un filtre de reconstruction complexe et encombrant, ni la mise en œuvre d'un système complexe d'alignement temporel de la tension de polarisation avec le signal à transmettre. Cependant, ils ont l'inconvénient de nécessiter davantage de cellules de commutation (une par niveau de tension), et donc de surface de substrat. Les deux solutions ont donc leurs avantages respectifs et peuvent s'avérer plus ou moins intéressantes en fonction des applications recherchées.

L'invention se place dans le cadre de ces commutateurs multi-niveaux, également connus comme des modulateurs CNA de puissance (acronyme de Convertisseur Numérique-Analogique), lorsqu'ils sont réalisés en technologie MMIC.

Il est connu des cellules de commutation de puissance à haute fréquence réalisées en technologie MMIC à partir de transistors à effet de champ, comme par exemple celle décrite dans la demande de brevet internationale WO 2015/162063. De telles cellules conviennent parfaitement à la réalisation d'un convertisseur multi-niveaux.

Cependant, la mise en œuvre de plusieurs de ces cellules en parallèle nécessite l'insertion d'un dispositif d'isolement des cellules entre elles, sans quoi les cellules de poids numérique inférieur consomment du courant, ce qui induit une perte de rendement. De plus, les cellules non isolées peuvent être soumises à des excursions en tension pouvant détruire leurs composants.

Ce problème est résolu dans l'art antérieur, hors technologie MMIC, par l'insertion de diodes entre les cellules.

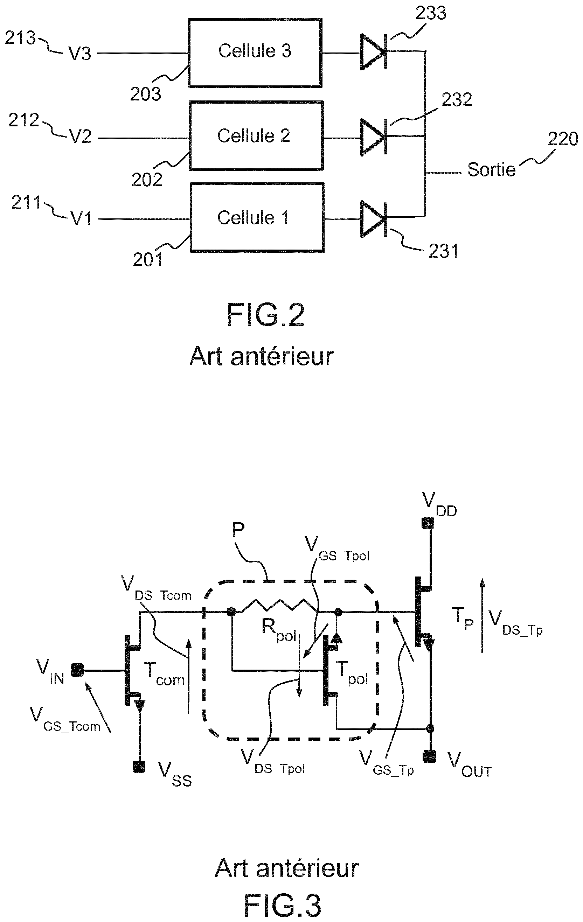

La figure 2 illustre un tel montage connu de l'état de l'art, comprenant des cellules de commutation isolées par des diodes.

Dans la figure 2, les cellules 201, 202 et 203 sont des cellules de commutation montées en parallèle, chacune des cellules étant reliée à une tension d'alimentation 211, 212 et 213 différente. Les cellules commutent en position allumée (ON) ou éteinte (OFF), de manière à délivrer une tension de sortie 220 dont le niveau varie en fonction des besoins.

Des diodes 231, 232 et 233 permettent d'isoler les cellules éteintes des cellules allumées.

L'utilisation de diodes pour isoler les différentes cellules de commutation n'est pas optimale lorsque le commutateur multi-niveaux est réalisé en technologie GaN MMIC. En effet, dans cette technologie planaire, la réalisation de diodes ne donne pas de caractéristiques viables pour ces applications en termes de tenue en courant, de résistances d'accès parasites et de capacités intrinsèques. Par exemple, les transistors montés « en diode » (c'est-à-dire source et drain reliés au même potentiel) ne permettent pas de transit de courants importants (car ces courants transitent alors à travers les doigts de grilles) ; les diodes planaires à contact Shottky circulaire ont une tenue en courant plus importante mais des résistances d'accès et une capacité intrinsèque élevées.

Ainsi, l'invention entend répondre à la problématique de réalisation d'un convertisseur multi-niveaux de puissance en technologie MMIC en proposant une cellule de commutation de puissance à haute vitesse de commutation, la cellule selon l'invention comprenant un dispositif d'isolement lui permettant d'être montée en parallèle avec d'autres cellules du même type sans diminution du rendement ou risque de destruction des composants.

La cellule de commutation de puissance selon l'invention comprend donc :

- un port d'entrée apte à recevoir un signal de commande de commutation,

- un transistor d'entrée ayant une grille reliée audit port d'entrée, et une source reliée à une tension de référence,

- un circuit d'auto-polarisation comprenant une résistance et un transistor d'auto-polarisation, une grille dudit transistor d'auto-polarisation étant reliée à un drain dudit transistor d'entrée, la résistance étant connectée en parallèle entre une grille et une source dudit transistor d'auto-polarisation et en série entre un drain du transistor d'entrée et une source dudit transistor d'auto-polarisation,

- un transistor de puissance, ayant une grille reliée à une source du transistor d'auto-polarisation et un drain relié à une tension d'alimentation, et une source reliée à un drain du transistor d'auto-polarisation, et

- un port de sortie.

Elle comprend en outre un transistor d'isolement ayant une grille reliée à une grille du transistor de puissance, une source reliée à une source du transistor de puissance et un drain relié audit port de sortie de la cellule.

Avantageusement, dans la cellule de commutation selon l'invention, le transistor de puissance, le transistor d'auto-polarisation et le transistor d'isolement sont des transistors à effet de champ de type normalement conducteur.

Avantageusement encore, les trois transistors sont des transistors à haute mobilité électronique (en anglais High Electron Mobility Transistor, ou HEMT), réalisés dans une technologie choisie dans la liste suivante : GaN (Nitrure de Galium), GaAs (Arséniure de Gallium).

Avantageusement, le transistor de puissance et le transistor d'auto-polarisation ont des caractéristiques électriques sensiblement identiques.

La cellule de commutation selon l'invention est dimensionnée de sorte que :

- la commutation à l'état passant du transistor d'entrée, par le signal d'entrée, commande la commutation à l'état bloqué desdits transistors d'auto-polarisation, de puissance et d'isolement, et

- la commutation à l'état bloqué du transistor d'entrée, par le signal d'entrée, commande la commutation à l'état passant desdits transistors d'auto-polarisation, de puissance et d'isolement.

Avantageusement, la cellule de commutation selon l'invention est réalisée en circuit intégré monolithique hyperfréquence ou technologie MMIC.

Dans un mode de réalisation de cette cellule, ledit transistor de puissance et ledit transistor d'isolement sont implémentés dans un motif unique comprenant un accès central de grilles, une source répartie de part et d'autre de l'accès central de grilles, un drain constitutif du transistor de puissance d'un côté de l'accès central de grilles, et un drain constitutif du transistor d'isolement d'un autre côté de l'accès central de grilles.

Avantageusement, ladite source et lesdits drains sont interdigités.

L'invention adresse également un convertisseur de tension multi-niveaux, caractérisé en ce qu'il comprend une pluralité de cellules de commutation telles que décrites précédemment, disposées en parallèle, chacune desdites cellules ayant un port de sortie relié à un même port de sortie dudit convertisseur multi-niveaux, et étant configurée pour fournir une tension de sortie différente de celle des autres cellules de commutation.

Enfin, l'invention adresse un système d'amplification d'un signal comprenant un amplificateur de puissance et un convertisseur de tension multi-niveaux tel que décrit ci-dessus, ledit convertisseur de tension multi-niveaux étant configuré pour générer une tension de polarisation dynamique de l'amplificateur de puissance.

*Description*

L'invention sera mieux comprise et d'autres caractéristiques et avantages apparaîtront mieux à la lecture de la description qui suit, donnée à titre non limitatif, et grâce aux figures annexées parmi lesquelles :

- Les figures 1a, 1b, 1c et 1d, déjà décrites, illustrent les enjeux liés à la gestion dynamique de tension de polarisation des amplificateurs de puissance ;

- La figure 2, déjà décrite, illustre un montage commutateur multi-niveaux selon l'état de l'art, réalisé dans une technologie autre qu'une technologie intégrée, et en particulier autre que la technologie MMIC ;

- La figure 3 représente une cellule de commutation en technologie MMIC, telle que décrite dans la demande de brevet internationale WO 2015/162063 ;

- La figure 4a représente une architecture possible de commutateur multi-niveaux (4 niveaux) comprenant des cellules de commutation selon l'état de l'art, isolées par des diodes ;

- La figure 4b donne le point de fonctionnement des transistors de puissance dans le montage présenté en figure 4a ;

- La figure 5a représente une architecture possible de commutateur multi-niveaux (4 niveaux) comprenant des cellules de commutation selon l'état de l'art, lorsqu'elles ne sont pas isolées entre elles ;

- La figure 5b donne le point de fonctionnement des transistors de puissance dans le montage présenté en figure 5a ;

- La figure 6 représente une cellule de commutation en technologie MMIC selon l'invention ;

- La figure 7 montre différentes résistances pouvant être ajoutées à la cellule de commutation selon l'invention ;

- La figure 8a représente une architecture possible de commutateur multi-niveaux (4 niveaux) comprenant des cellules de commutation selon l'invention ;

- La figure 8b donne le point de fonctionnement des transistors de puissance et des transistors d'isolement dans le montage présenté en figure 8a ;

- La figure 9 donne un exemple de commutation de tension en sortie d'un commutateur multi-niveaux comprenant des cellules de commutations selon l'invention, réalisé en simulation.

- La figure 10a représente un exemple de réalisation en technologie MMIC des transistors de puissance et d'isolement dans une cellule de commutation selon l'invention.

L'invention est décrite sous la forme d'une cellule de commutation pour un convertisseur multi-niveaux utilisé pour la gestion dynamique de la polarisation d'amplificateurs de puissance. Cependant, cette description n'est pas limitative, la cellule de commutation selon l'invention pouvant être utilisée dans d'autres types de dispositifs que des convertisseurs multi-niveaux, et pour d'autres finalités que la gestion de la tension de polarisation d'amplificateurs de puissance, comme par exemple des générateurs de signaux arbitraires de puissance pour l'instrumentation.

De même, la cellule de commutation de puissance selon l'invention est réalisée à partir de transistors à appauvrissement (aussi connus comme transistors à « déplétion » ou transistors normalement conducteurs, en anglais « normally-ON »), ce qui est souvent le cas des transistors RF (GaN, AsGa, etc...). Cependant, pour ce qui concerne le transistor de commande $T_{com}$ l'invention peut s'appliquer de manière identique quel que soit le type de transistors utilisés (en utilisant par exemple des transistors normalement fermés, en anglais « normally-off »). L'homme du métier est en mesure de modifier les valeurs pertinentes de la cellule de commutation, comme par exemple les valeurs des tensions de commande des transistors, pour les adapter aux types et aux modèles de transistors utilisés, les valeurs de tension et d'intensité décrites par la suite n'étant mentionnées qu'à titre d'illustration.

Enfin, l'invention s'applique de préférence à une cellule de commutation de puissance réalisée en technologie MMIC, mais la cellule de commutation et le convertisseur multi-niveaux selon l'invention peuvent être réalisés de façon équivalente dans n'importe quel type de technologie, par exemple sur circuit imprimé PCB avec des composants discrets montés en surface.

L'utilisation de transistors dits « RF », c'est-à-dire généralement prévus pour des applications à des fréquences RF ou micro-ondes, permet de réaliser des cellules de commutations répondant aux besoins de vitesse de commutation et de faible consommation électrique du suivi d'enveloppe d'un signal à amplitude non constante. Les transistors à haute mobilité électronique, notamment les transistors HEMTs en technologie GaN, sont adaptés à ce type de réalisation en ce qu'ils sont capables de conduire des courants importants à des tensions élevées (leur conférant ainsi de bonnes dispositions pour être utilisés dans des circuits de puissance) tout en ayant des capacités intrinsèques faibles par rapport aux autres technologies.

Une des principales difficultés de réalisation de circuits de commutations rapides réside dans la réalisation de la commande des transistors de puissance dont le potentiel de source est flottant, c'est-à-dire non référencé à un potentiel fixe (généralement la masse) : elle varie entre un potentiel proche de zéro et un potentiel correspondant au niveau de la haute tension à commuter. Les techniques d'isolation de la commande de grille grâce à des optocoupleurs ou des transformateurs d'isolement ne semblent pas convenir pour ces applications à haute fréquence de commutation à cause de leur relative lenteur.

Par ailleurs, une particularité notable de nombreux transistors RF à effet de champ, et en particulier de la plupart des HEMTs GaN, est qu'ils ont un mode de fonctionnement dit « à déplétion », c'est-à-dire que leur canal est ouvert lorsque la tension appliquée entre leur grille et leur source est nulle. Dans ces conditions, si la tension entre drain et source n'est pas nulle, un courant non nul peut circuler entre drain et source. Pour arriver à bloquer un tel transistor, il faut dépléter son canal de charges libres, ce qui est obtenu en appliquant une tension grille-source négative (tension de pincement du transistor). Dans la littérature technique anglo-saxonne, on parle de transistors « normally ON ». L'utilisation de transistors « normally-ON », si elle ne pose pas de difficulté particulière, n'est pas courante pour des applications de commutation et nécessite d'adapter les architectures connues à cette spécificité.

Le contrôle de polarisation de grille d'un transistor de puissance doit ainsi être conçu pour tout à la fois :

- s'adapter à la spécificité « normally-ON » de nombreux transistors RF à effet de champ,

- permettre une commutation rapide, sans risquer un claquage du transistor, c'est-à-dire avec une tension de grille qui évolue de façon bien maîtrisée par rapport à la tension de source flottante,

- garantir la sécurité du dispositif en assurant la mise à l'état « OFF » lors de la mise sous tension de celui-ci.

Par ailleurs les pertes électriques du commutateur doivent être les plus faibles possibles :

- en commutant (passage de l'état « ON » à l'état « OFF » et de l'état « OFF » à l'état « ON ») de façon la plus rapide possible, pour limiter les pertes de commutation, ce qui est rendu possible par le choix de la technologie de composants et par la réalisation d'un circuit de commande de grille adapté, et

- en limitant les pertes de conduction : en choisissant des transistors ayant des résistances à l'état passant les plus faibles possible, et en limitant leurs fuites de courant de sortie à l'état bloqué, lorsque leur tension de sortie est maximale, proche de la tension d'alimentation.

Dans la suite du document, et sauf mention contraire, les transistors utilisés sont des transistors à effet de champ, de type « normally-ON ». Ces transistors sont constitués d'une grille métallique, d'un drain et d'une source. A l'état « ON », c'est-à-dire leur tension grille-source est proche de 0V, ces transistors sont passants tandis qu'ils sont bloqués (circuit ouvert) à l'état « OFF », c'est-à-dire lorsque leur tension grille-source est négative.

La figure 3 représente une cellule de commutation de puissance pouvant être réalisée en technologie MMIC, telle que décrite dans la demande de brevet internationale WO 2015/162063.

Cette cellule comprend :

- une commande, configurée pour délivrée une tension $V_{IN}$ ;

- un transistor $T_{com}$, dit transistor d'entrée ou de commande, dont la source est reliée à une source de tension $V_{SS}$;

- un transistor $T_p$, dit transistor de puissance, dont le drain est relié à une source de haute tension $V_{DD}$;

- un circuit de polarisation P, comprenant un transistor $T_{pol}$, dit transistor de polarisation et une résistance $R_{pol}$, dite résistance de polarisation ;

la cellule de commutation délivrant une tension de sortie $V_{OUT}$.

Le rôle du transistor d'entrée est de commuter un courant faible, lié à la source de tension $V_{SS}$, vers la charge formée par le circuit d'auto-polarisation P et le transistor de puissance $T_p$. Le courant commuté par $T_{com}$ est faible, en comparaison du courant commuté par le transistor de puissance et le transistor de polarisation. Ainsi, le transistor d'entrée $T_{com}$ peut être choisi du même type que les transistors $T_p$ et $T_{pol}$, c'est-à-dire des transistors à effet de champ de type HEMT « normally-ON », ou de type différent, comme par exemple un transistor MOS (acronyme anglais pour Metal Oxide Semiconductor) « normally-OFF ». Le transistor $T_p$ commute des courants plus élevés. Son développement de grille est choisi de manière à ce qu'il fonctionne dans sa zone ohmique (c'est-à-dire que $V_{DS\_TP(ON)}$ reste faible) lors du passage de tels courants.

Lorsque le transistor $T_{com}$ est à l'état ON (par exemple lorsque $V_{IN}=V_{SS}$), les transistors $T_p$ et $T_{pol}$ s'autopolarisent. En effet, le courant I commuté par le transistor de commande $T_{com}$ contrôle le point de fonctionnement du transistor $T_{pol}$ du circuit d'auto-polarisation : ce courant fixe la tension grille-source $V_{GS\_Tpol}$, avec $V_{GS\_Tpol}=I.R_{pol}$, et le courant drain source $I_{DS\_Tpol}$, avec $I_{DS\_Tpol}=I$, le courant du transistor $T_{pol}$. A ce point de fonctionnement correspond une valeur déterminée de tension drain source $V_{DS\_Tpol}$ du transistor de polarisation $T_{pol}$.

Par construction, la tension drain-source $V_{DS\_Tpol}$ du transistor de polarisation $T_{pol}$ est égale à l'inverse de la tension grille-source $V_{GS\_Tp}$ du transistor de puissance $T_p$. Ainsi, le transistor de commande $T_{com}$ commuté à l'état ON permet le contrôle en courant de la tension grille-source du transistor de commutation de puissance $T_p$ à l'état OFF ($V_{GS\_Tp(OFF)}$).

Il s'agit d'un contrôle indirect, puisque le courant I, commuté par le transistor de commutation $T_{com}$ est en fait fourni par la structure de la cellule. Les valeurs du courant I et de la tension $V_{GS\_Tp(OFF)}$ ne sont ainsi pas directement réglables. On les règle indirectement, par un dimensionnement approprié de la structure de la cellule, et notamment par un choix approprié des valeurs de la résistance $R_{pol}$ et de la tension $V_{SS}$, avec :

$$V_{GS\_Tp(OFF)} = \left[ \frac{R_L.G_{m\_Tp} - 1 - V_{SS}}{R_L.G_{m\_Tp} + 1} - \frac{G_{m\_Tpol}.(R_{pol} + R_L)}{(R_L.G_{m\_Tp} + 1).(R_{pol}.G_{m\_Tpol} + 1)} \right].V_P$$

avec :

- $R_L$ la résistance de charge en sortie de cellule,
- $G_{m\_Ti}$ la transconductance du transistor $T_i$
- $V_p$ la tension de pincement des transistors $T_p$ et $T_{pol}$, dans le cas où ces derniers ont la même tension de pincement, ce qui est habituellement le cas s'ils sont en même technologie MMIC.

Lorsque le transistor $T_{com}$ est à l'état ON, les transistors $T_p$ et $T_{pol}$ sont donc à l'état OFF, et la cellule de commutation est à l'état OFF. A la mise sous tension de la cellule, la commande du transistor $T_{com}$ est égale à 0V garantissant ainsi que la cellule est à l'état OFF et isolée de la charge quelle que soit la tension d'alimentation de drain.

Lorsque le transistor $T_{com}$ est à l'état OFF (par exemple lorsque $V_{IN} = V_p + V_{SS}$), c'est-à-dire qu'il ne conduit plus de courant vers la charge formée du circuit d'auto-polarisation P et du transistor de puissance $T_p$, le transistor $T_{pol}$ est commuté dans l'état passant ON. Dans cet état, il est équivalent, en sa sortie, à une résistance $R_{DS\_Tpol(ON)}$, connectée entre la grille et la source du transistor de puissance $T_p$, de très faible valeur. Le transistor $T_p$ est lui aussi à l'état passant ON, la cellule de commutation délivrant alors une tension de sortie $V_{OUT} = V_{DD}$.

La vitesse de commutation de l'état OFF à l'état ON du transistor $T_p$, correspond à la vitesse de commutation de la cellule. Cette vitesse est liée à l'impédance présentée à l'entrée de $T_p$, une impédance faible favorisant une commutation rapide. En d'autres termes, pendant la phase de commutation, le transistor $T_{pol}$ doit être équivalent en sa sortie à une résistance de faible valeur. C'est le cas lorsque le transistor $T_{pol}$ est dans l'état passant. Pendant la phase transitoire de commutation, $T_{pol}$ lui aussi commute de l'état quasi-bloqué à l'état passant. Il présente alors à $T_p$ une résistance qui varie d'une valeur importante à une valeur faible. Dans la pratique, $T_{pol}$ a un développement bien inférieur à $T_p$ car il n'a pas à conduire de courant fort. Sa capacité d'entrée est donc beaucoup plus faible que la capacité d'entrée de $T_p$, il peut ainsi commuter très rapidement. Sa résistance équivalente de sortie équivaut donc très rapidement à sa résistance à l'état passant, faible, ce qui permet également à $T_p$ de commuter très rapidement.

Cette cellule permet donc une commutation rapide d'un courant fort à partir d'un signal de commande d'une puissance faible. Elle est en outre facilement paramétrable, et présente peu de pertes lorsque la cellule est à l'état OFF, ainsi que de pertes en commutation. Une telle cellule, réalisée à partir de HEMTs GaN, permet d'atteindre des rendements et des vitesses de commutation inatteignables avec des architectures plus classiques de convertisseurs DC-DC, et ouvrent la voie à la réalisation de modulateurs de polarisation pour les applications d' « envelope tracking », ou poursuite d'enveloppe. Leur spécificité repose sur l'existence du circuit d'auto-polarisation du transistor de puissance qui, dit plus simplement, génère lui-même le courant dont le transistor de puissance a besoin pour commuter, lors d'un changement d'état du transistor de commande.

Des exemples de réalisation d'un commutateur multi-niveaux sont donnés dans la suite du document, à partir de composants HEMTs AlInN/GaN (Nitrure d'Indium et d'Aluminium) développés en laboratoire, de longueur de grille $0,25\mu m$ et de développement total de grille de 1,5mm (sous la forme de 10 doigts de $150\mu m$ de long).

Ces exemples présentent le cas d'un convertisseur numérique analogique de puissance à 4 niveaux, pour lequel les quatre tensions de sortie possibles sont 40V (bit 11), 30V (bit 10), 20V (bit 01), et 10V (bit 00).

On cherchera à obtenir en sortie la tension la plus grande, soit le bit '11'. Les cellules C0, C1 et C2 sont donc commandées à l'état « OFF », et la cellule à l'état C3 à l'état « ON ».

Ces exemples sont donnés à titre d'illustration non limitatif, l'homme du métier étant à même de les adapter en ajoutant ou en supprimant des cellules, en modifiant les composants, les tensions délivrées, ou l'état des cellules.

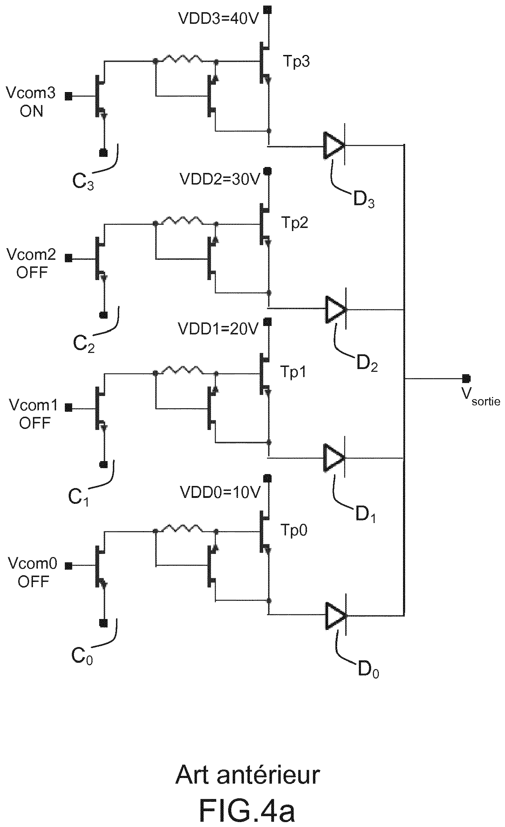

La figure 4a représente une architecture possible de commutateur multi-niveaux comprenant des cellules de commutation selon l'état de l'art, les cellules étant isolées par des diodes. Le commutateur est un montage hybride, les cellules pouvant être réalisées en technologie MMIC, contrairement aux diodes, pour les raisons précédemment décrites.

Le commutateur présente donc quatre cellules, C0, C1, C2 et C3, chacune des cellules étant reliées à une alimentation $V_{DDi}$ différente. Les cellules sont conformes à celle décrite en figure 3. Elles comportent chacune un transistor de puissance, ces transistors étant nommés respectivement $T_{p0}$, $T_{p1}$, $T_{p2}$, et $T_{p3}$, et sont isolées entre elles par des diodes nommées $D_0$, $D_1$, $D_2$ et $D_3$.

La commande d'entrée est telle que :

- le transistor de puissance $T_{p3}$ est dans l'état « ON », ce qui induit que la tension de sortie $V_{sortie}$ vaut $V_{sortie} = V_{DD3}$ = 40V.
- les autres transistors de puissance sont dans l'état « OFF ».

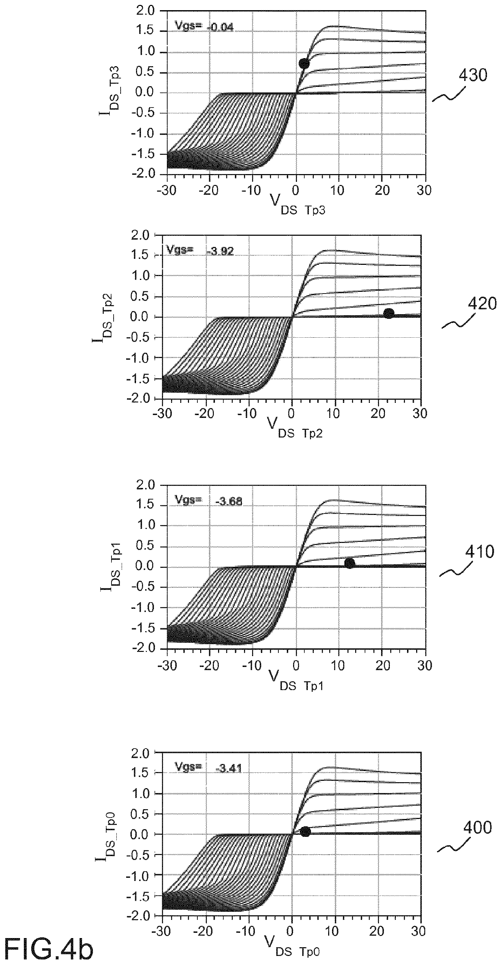

La figure 4b donne le point de fonctionnement des transistors de puissance dans le montage présenté en figure 4a.

Les graphiques 400, 410, 420 et 430 donnent respectivement les courbes d'excursions possibles $I_{DS}(V_{DS})$ de chacun des transistors de puissance $T_{p0}$, $T_{p1}$, $T_{p2}$, et $T_{p3}$, sur lesquelles apparaissent les points de fonctionnement du transistor.

On observe, sur la figure 430 en relation avec le fonctionnement du transistor de puissance $T_{p3}$, que la tension grille-source $V_{GS3}$ vaut approximativement 0V, ce qui correspond à un état ON du transistor (transistor « normally-ON »).

Le point de fonctionnement, pour la courbe d'excursion associée, fait état d'une tension $V_{DS3}$ dans le transistor $T_{p3}$ proche de zéro. Par conséquent, la tension de sortie $V_{sortie} = V_{DD3} = 40V$.

Concernant la cellule $C_2$, la figure 420 en relation avec le fonctionnement du transistor de puissance $T_{p2}$, indique que la tension grille-source $V_{GS\_Tp2}$ vaut environ -4V, ce qui correspond à un état « OFF » du transistor.

Le point de fonctionnement, pour la courbe d'excursion associée, fait état d'une tension $V_{DS\_Tp2}$ dans le transistor $T_{p2}$ de 22V. Cette valeur correspond à $V_{DD2} + 2 * V_p$, $V_p$ valant environ -4V. Ainsi, le courant de sortie de cette cellule est nul.

Il en va de même pour la tension en sortie des cellules $C_1$ et $C_0$.

Pour les cellules de commutations en état « OFF », les tensions grille-source $V_{GS}$ sont de l'ordre de -3.5V à -4V, et les tensions $V_{DS}$ aux bornes des transistors de puissance sont égales à leurs $V_{DD}$ respectifs plus deux fois la tension de pincement des transistors. Le commutateur fonctionne donc de manière nominale.

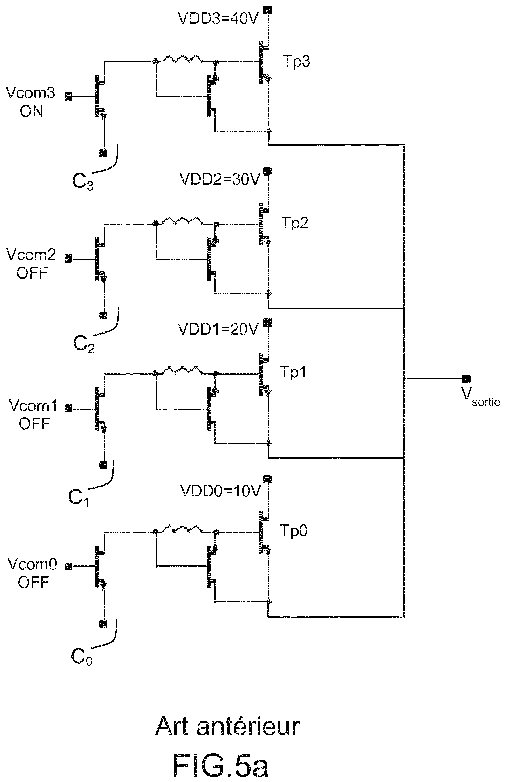

La figure 5a représente une architecture possible de commutateur multi-niveaux comprenant des cellules de commutation selon l'état de l'art, lorsqu'elles ne sont pas isolées entre elles (4 niveaux de tensions).

Cette figure ne diffère de celle présentée dans la figure 4a que par le fait que les diodes $D_0$ à $D_3$ ont été supprimées. Le circuit peut donc être réalisé intégralement en technologie MMIC.

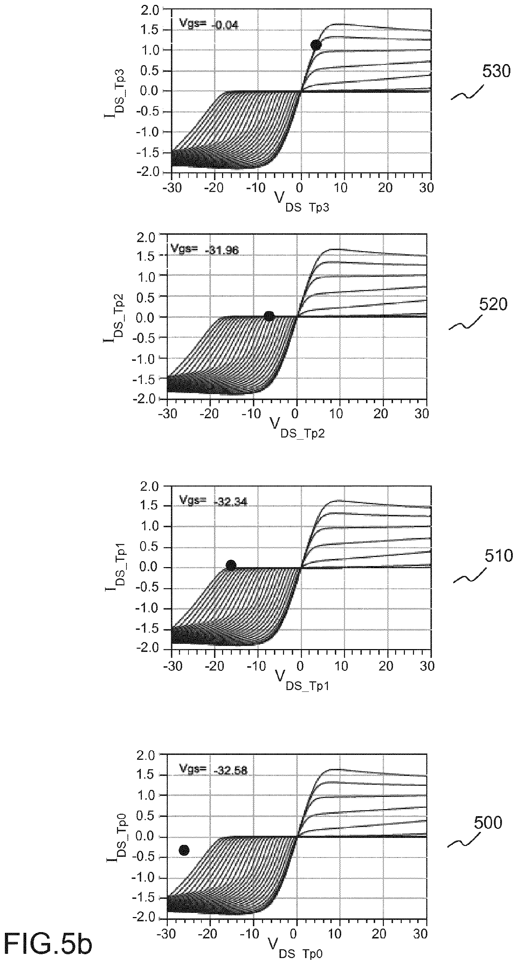

La figure 5b donne le point de fonctionnement des transistors de puissance dans le montage présenté en figure 5a.

Les graphiques 500, 510, 520 et 530 donnent respectivement les courbes d'excursions possibles I(V) de chacun des transistors de puissance $T_{p0}$, $T_{p1}$, $T_{p2}$, et $T_{p3}$, sur lesquels apparaissent les points de fonctionnement du transistor.

Comme dans le montage où les cellules sont isolées par des diodes, on observe que dans la cellule de commutation $C_3$, la tension grille-source $V_{GS3}$ du transistor vaut approximativement 0V, ce qui correspond à un état « ON » du transistor.

Le point de fonctionnement, pour la courbe d'excursion associée, fait état d'une tension $V_{DS3}$ dans le transistor $T_{p3}$ proche de zéro. Par conséquent, la tension de sortie $V_{sortie} = V_{DD3} - V_{DS\_Tp3} \approx 40V$.

Concernant la cellule de commutation $C_2$, cette cellule n'est plus isolée, et présente donc un potentiel aux bornes du transistor $T_{p2}$ valant $V_{GS\_Tp2} = -32V$. Cette tension est destructive pour la plupart des technologies de transistors, et constitue une limitation de la plage d'utilisation de cette cellule, car cette tension est liée à la valeur de $V_{DD3}$.

Le transistor $T_{p2}$ a une tension $V_{DS2}$ négative, Cependant, il ne conduit pas de courant car sa tension $V_{GS}$ est bien plus négative que sa tension $V_{DS}$. La cellule est donc bien à l'état « OFF ».

Le comportement de la cellule $C_1$ est en tout point identique à celui de la cellule $C_2$.

Concernant la cellule de commutation $C_0$, le potentiel aux bornes du transistor $T_{p0}$ vaut également $V_{GS\_Tp0} = -32V$. Tout comme pour les cellules $C_2$ et $C_1$, une telle tension est susceptible de détruire le transistor.

On remarque de plus que le point de fonctionnement, pour la courbe d'excursion associée, fait état d'une tension $V_{DS\_Tp0}$ qui est négative. Etant donné la valeur de ses tensions $V_{DS}$ et $V_{GS}$, le transistor de puissance est dans un mode de conduction négatif et délivre un courant $I_{DS}$ négatif ($I_{DS\_Tp0} \approx -0,35A$). Il dissipe alors de la puissance, ce qui contribue à diminuer le rendement électrique de la cellule.

Ainsi, le montage représenté dans la figure 5a illustre bien le besoin d'une isolation des cellules de commutation entre elles, l'absence d'isolation pouvant aboutir à une diminution du rendement, et une destruction des transistors de puissance.

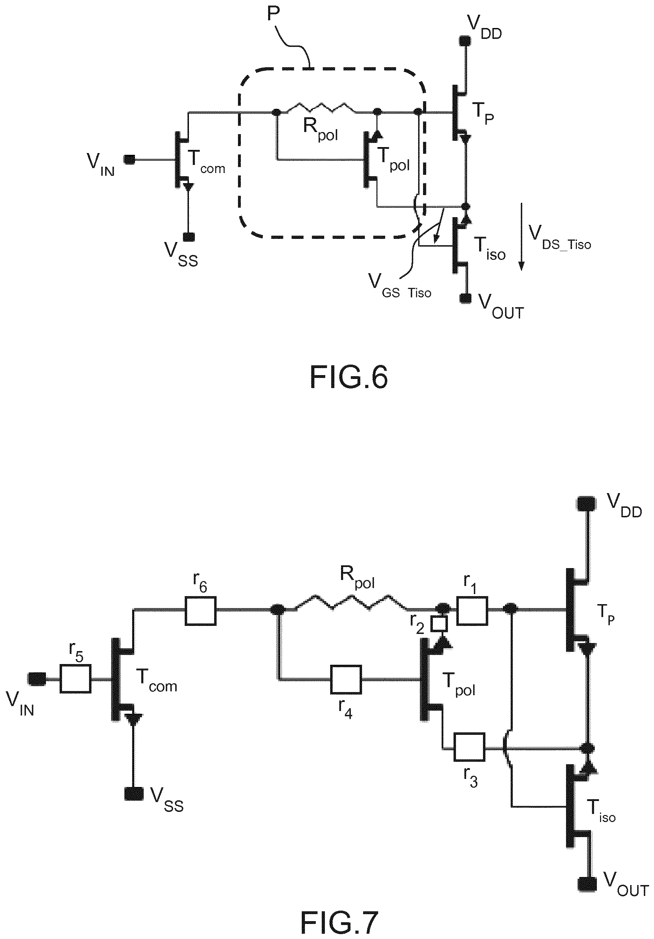

La figure 6 représente une cellule de commutation en technologie MMIC selon l'invention.

Cette cellule de commutation se distingue de celle représentée en figure 3 en ce qu'elle comprend un transistor supplémentaire, dit transistor d'isolement, ou $T_{iso}$, jouant le même rôle qu'une diode, et pouvant être implémenté en technologie MMIC.

Le transistor d'isolement de la cellule de commutation selon l'invention est relié par sa grille à la grille du transistor de puissance $T_p$. Ainsi, les deux transistors sont commandés par la même tension d'alimentation, ils sont donc systématiquement dans le même état.

Il est également monté de manière symétrique au transistor de puissance $T_p$, c'est-à-dire que sa source est reliée à la source du transistor de puissance. Les deux transistors ayant une grille et une source commune, la tension grille-source du transistor de puissance $V_{GS\_Tp}$ vaut la tension grille-source du transistor d'isolement $V_{GS\_iso}$.

Les transistors de puissance et d'isolement commutant des charges de même puissance, ils sont avantageusement choisis parmi des transistors ayant des caractéristiques électriques similaires.

Lorsque la cellule est à l'état « ON », la tension grille-source du transistor d'isolement $V_{GS\_iso}$ est proche de 0V, le transistor $T_{iso}$ est donc passant et sa tension $V_{DS-iso}$, est très faible, ce qui a pour effet de n'impacter qu'à la marge la tension de sortie $V_{OUT}$ de la cellule.

Lorsque la cellule est à l'état « OFF », la tension grille-source du transistor d'isolement $V_{GS\_iso}$ est négative. Le transistor d'isolement se comporte alors comme un circuit ouvert, ce qui a pour effet d'isoler la sortie de la cellule de commutation.

La cellule de commutation selon l'invention conserve les propriétés de commutation rapide de la cellule de commutation représentée en figure 3, la commutation étant légèrement moins rapide que pour cette dernière car le circuit d'auto-polarisation doit commander deux transistors de taille identique au lieu d'un seul.

La cellule de commutation selon l'invention conserve également la propriété de fort rendement de la cellule de commutation connue de l'état de l'art, tout en présentant de plus des propriétés d'isolation de la cellule, par le biais d'un dispositif réalisable en technologie MMIC.

Le fonctionnement de cette cellule peut encore être ajusté, par ajout de résistances sur certaines connexions de la cellule, dans le but de rendre ces connexions plus résistives. Ces résistances, optionnelles et indépendantes, permettent en pratique de réaliser des réglages fins, dans le but d'améliorer le rendement de la cellule en fonction des conditions d'utilisation opérationnelles. Il s'agit principalement, par ces résistances, d'améliorer la marge de stabilité des transistors et de limiter des effets de surtension ou de rebonds induits par des selfs parasites de la structure, néfastes au rendement.

La figure 7 montre ainsi différentes résistances pouvant être prévues dans la structure de cellule de commutation selon l'invention.

En particulier :

- la connexion entre la grille du transistor de puissance $T_p$ et la résistance d'auto-polarisation $R_{pol}$, et entre la grille du transistor d'isolement $T_{iso}$ et la résistance d'auto-polarisation $R_{pol}$ peut comprendre une résistance $r_1$;

- la connexion entre la résistance d'auto-polarisation $R_{pol}$ et la source du transistor $T_{pol}$ peut comprendre une résistance $r_2$;

- la connexion entre le drain du transistor d'auto-polarisation $T_{pol}$ et la source du transistor de puissance $T_p$ et du transistor d'isolement $T_{iso}$ peut comprendre une résistance $r_3$;

- la connexion entre la résistance d'auto-polarisation $R_{pol}$ et la grille du transistor d'auto-polarisation $T_{pol}$ peut comprendre une résistance $r_4$;

- la connexion entre le port d'entrée et la grille du transistor d'entrée $T_{com}$ peut comprendre une résistance $r_5$;

- la connexion entre le drain du transistor d'entrée $T_{com}$ et la résistance $R_{pol}$ peut comprendre une résistance $r_6$.

La valeur de chacune de ces résistances $r_1$ à $r_6$ est en pratique déterminée par simulation des conditions opérationnelles, pour une application donnée. Selon les cas, à l'issue de la simulation, zéro, une, plusieurs ou toutes ces résistances seront déterminées avec une valeur non nulle.

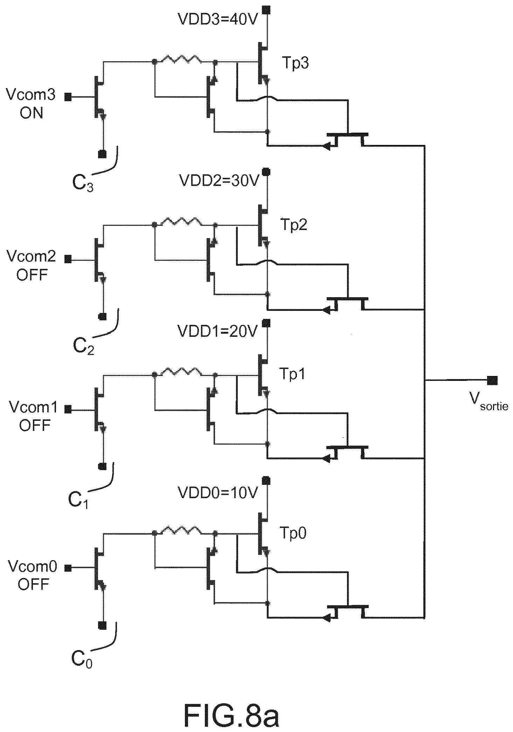

La figure 8a représente une architecture possible de commutateur multi-niveaux (quatre niveaux) comprenant des cellules de commutation selon l'invention.

Ce commutateur est composé de quatre cellules : C0, C1, C2 et C3, chacune des cellules étant reliée à une alimentation $V_{DDi}$ différente. Les cellules sont conformes à celle décrite en figure 6. Elles comportent toutes un transistor de puissance nommé respectivement $T_{p0}$, $T_{p1}$, $T_{p2}$, et $T_{p3}$, et un transistor d'isolement nommé respectivement $T_{iso0}$, $T_{iso1}$, $T_{iso2}$, et $T_{iso3}$.

Le transistor de puissance Tp3 est dans l'état « ON », ce qui induit que la tension de sortie $V_{sortie}$ vaut $V_{sortie} = V_{DD3} = 40V$.

Les autres transistors de puissance sont dans l'état « OFF ».

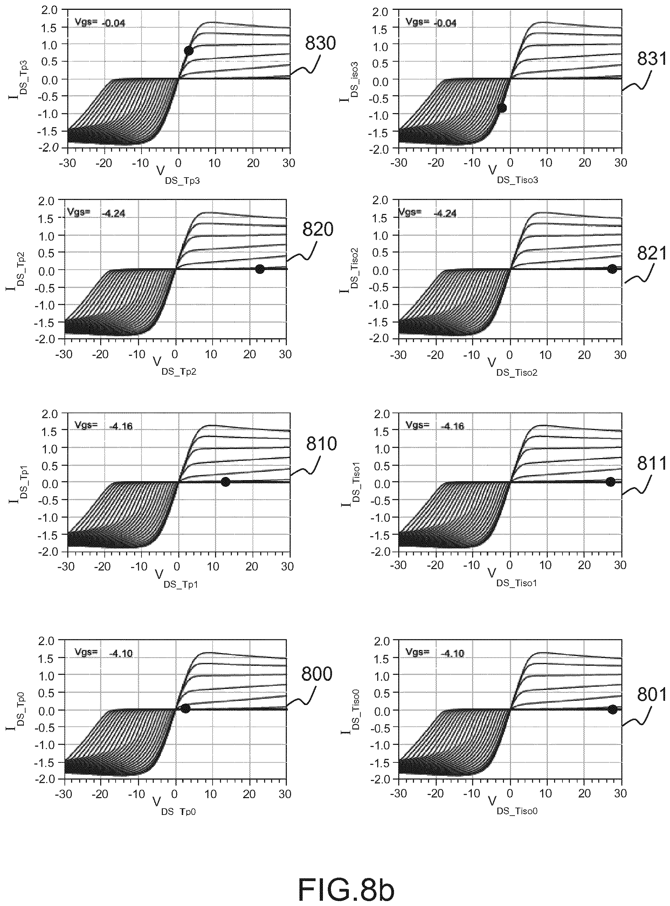

La figure 8b donne le point de fonctionnement des transistors de puissance dans le montage présenté en figure 8a.

Les graphiques 800, 810, 820 et 830 donnent respectivement les courbes d'excursions possibles I(V) de chacun des transistors de puissance $T_{p0}$, $T_{p1}$, $T_{p2}$, et $T_{p3}$, sur lesquels apparaissent les points de fonctionnement du transistor.

Les graphiques 801, 811, 821 et 831 donnent respectivement les courbes d'excursions possibles I(V) de chacun des transistors d'isolement $T_{iso0}$, $T_{iso1}$, $T_{iso2}$, et $T_{iso3}$, sur lesquels apparaissent les points de fonctionnement du transistor.

Concernant la cellule $C_3$, on observe, sur la figure 830 en relation avec le fonctionnement du transistor de puissance $T_{p3}$, que la tension grille-source $V_{GS\_Tp3}$ du transistor vaut approximativement 0V, ce qui correspond à son état « ON ».

Le point de fonctionnement, pour la courbe d'excursion associée, fait état d'une tension $V_{DS3\_Tp3}$ dans le transistor $T_{p3}$ proche de zéro (dans le cas d'application, $V_{DS\_Tp3}$ vaut environ 3V).

Concernant la cellule $C_2$, la figure 820 en relation avec le fonctionnement du transistor de puissance $T_{p2}$, indique que sa tension grille-source $V_{GS2}$ vaut environ -4V, ce qui correspond à un état « OFF » du transistor.

Le point de fonctionnement, pour la courbe d'excursion associée, fait état d'une tension $V_{DS2}$ dans le transistor $T_{p2}$ de 22V. Cette valeur correspond à $V_{DD2}$ + 2 * $V_p$, $V_p$ valant environ -4 V. Ainsi, le courant de sortie de cette cellule est nul.

Il en va de même pour la tension en sortie des cellules $C_1$ et $C_0$.

Les cellules à l'état « OFF » sont donc bien isolées, et le point de fonctionnement des transistors de puissance se situe dans leur plage normale d'utilisation, ne risquant ainsi pas de les détruire. On n'observe pas de fuite de courant, le rendement du commutateur est donc optimal.

Le comportement des transistors de puissance est donc similaire au comportement observé lorsque les cellules sont isolées par des diodes, ce qui est le but recherché par l'invention.

Concernant les transistors d'isolement, on observe, sur la figure 831 en relation avec le fonctionnement du transistor d'isolement $T_{iso3}$, que la tension grille-source $V_{GS\_Tiso3}$ du transistor d'isolement vaut approximativement 0V, ce qui correspond à son état « ON ». Le transistor d'isolement laisse passer le courant, ce qui permet de délivrer une charge à la sortie du circuit.

Le point de fonctionnement, pour la courbe d'excursion associée, fait état d'une tension $V_{DS\_Tiso3}$ dans le transistor $T_{iso3}$ proche de zéro (dans le cas d'application précis, $V_{DS\_Tiso3} \approx$ -3V). Par conséquent, la tension de sortie $V_{sortie} = V_{DD3} - V_{DS\_Tp3} + V_{DS\_Tiso3} \approx 34V$, $V_{DS\_Tp3}$ étant la tension drain-source du transistor de puissance $T_{p3}$ et $V_{DS\_iso3}$ étant la tension drain-source du transistor d'isolement $T_{iso3}$.

Pour les cellules de commutations $C_2$, en état « OFF », la tension grille source du transistor d'isolement $V_{GS\_Tiso2}$ est donc de l'ordre de -4V, ce qui la situe dans la plage de fonctionnement nominal du transistor, sans risque de destruction de ce dernier. La tension $V_{DS\_Tiso2}$ du transistor d'isolement vaut 26V, ce qui correspond à $V_{OUT}$ - ($V_{DD2}$ - $V_{DS\_Tp2}$) = 34V - (30V - 22V) = 26V, avec $V_{DS\_Tp2}$ la tension drain source du transistor de puissance $T_{p2}$. Le transistor d'isolement joue donc parfaitement son rôle, en absorbant la tension de sortie afin de protéger les cellules à l'état « OFF », tout en restant à des points de fonctionnement non stressants.

L'analyse est la même pour les cellules de commutation $C_1$ et $C_0$:

- dans $C_1$, la tension $V_{DS\_Tiso1}$ du transistor d'isolement $T_{iso1}$ vaut 26V = $V_{OUT}$ - ($V_{DD1}$ - $V_{DS\_Tp1}$) = 34V - (20V - 12V) ;

- dans $C_0$, la tension $V_{DS\_Tiso0}$ du transistor d'isolement $T_{iso0}$ vaut 26V = $V_{OUT}$ - ($V_{DD0}$ - $V_{DS\_Tp0}$) = 34V - (10V - 2V),

les transistors d'isolement jouant là aussi leur rôle, les tensions $V_{GS}$ des transistors de puissance et d'isolement étant maintenues dans leur plage de fonctionnement nominal, et les cellules à l'état « OFF » ne consommant pas de courant.

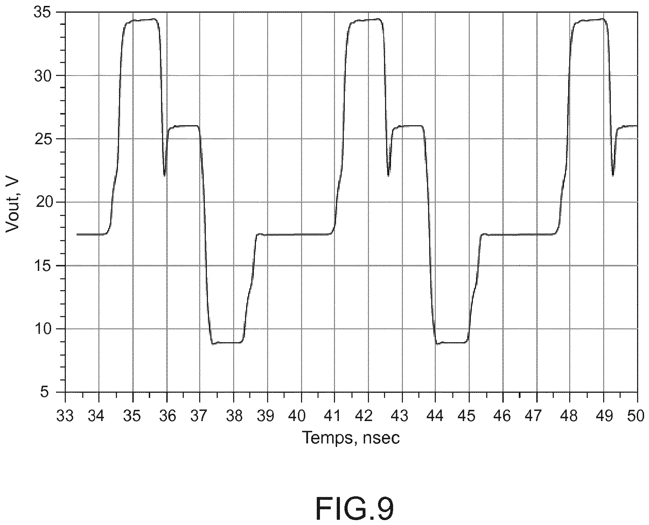

La figure 9 donne un exemple de commutation de tension en sortie d'un commutateur multi-niveaux à quatre niveaux comprenant des cellules de commutation isolées selon l'invention, réalisé en simulation à partir des transistors décrits précédemment, et permettant de commuter des tensions jusqu'à 40V sur une charge de 50ohms.

Chaque état de tension a une durée de 1,33ns, soit une fréquence de commutation de chaque cellule de 750MHz. Un signal sinusoïdal nécessitant 6 états de tension pour être reproduit, ce circuit peut convertir des signaux ayant des fréquences de 125MHz. On observe des temps de montée et de descente entre les différents niveaux de tension délivrés de l'ordre de 0,4ns.

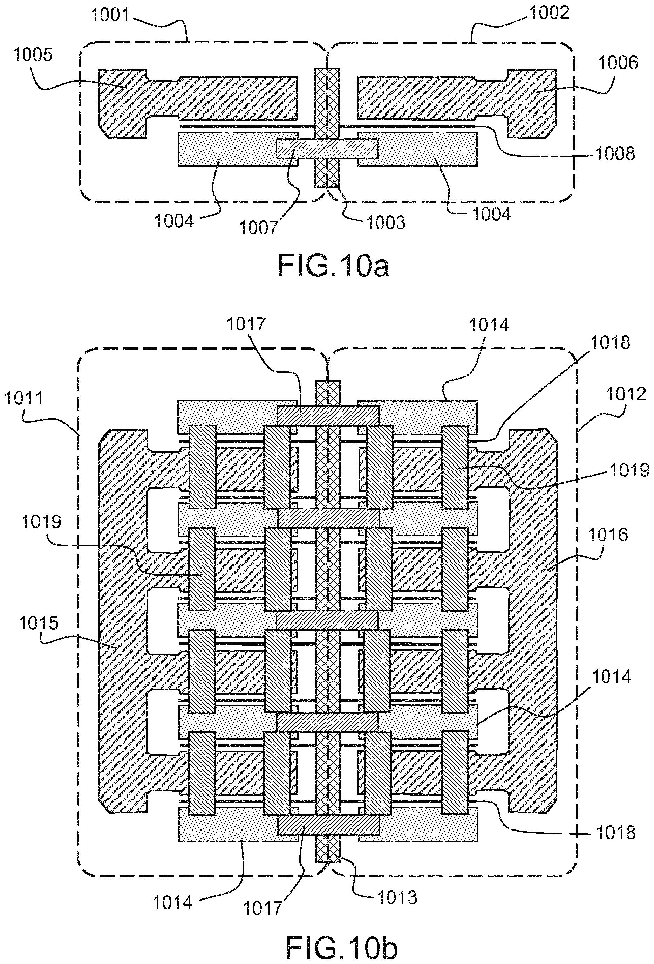

Dans la cellule de commutation selon l'invention, le transistor de puissance et le transistor d'isolement partagent la même grille et la même source. L'implémentation de ces deux transistors dans un circuit intégré peut donc être réalisée avantageusement en mutualisant les éléments communs, de manière à réduire l'occupation de la cellule, tel que représenté sur les figures 10a et 10b.

Ces exemples sont donnés à titre d'illustration, et ne sont pas limitatifs, l'homme du métier pouvant facilement trouver d'autres dispositions équivalentes à partir de ses connaissances générales.

A cet effet, la figure 10a représente un exemple de réalisation en technologie MMIC des transistors de puissance et d'isolement dans une cellule de commutation selon l'invention.

Le transistor de puissance 1001 et le transistor d'isolement 1002 sont réalisés au sein d'un unique motif actif compact comprenant un accès central de grilles 1003, permettant le pilotage des grilles par un même courant de commande, et une source 1004 commune aux deux transistors, répartie de part et d'autre de l'accès central de grille, et reliée entre ses deux parties par un pont de source 1007, qui passe au dessus de l'accès central de grille.

Le transistor de puissance 1001 comprend également un drain 1005, présentant un accès, et positionné d'un côté de l'accès central de grilles.

Le transistor d'isolement 1002 comprend un autre drain 1006, présentant un accès différent du drain 1005, et positionné de l'autre côté de l'accès central de grilles

Enfin, le motif comprend un doigt de grille 1008, relié à l'accès central de grille, et qui s'étend entre la source 1004 et les drains 1005 et 1006.

La figure 10b représente un autre exemple de réalisation en technologie MMIC, plus avantageuse, des transistors de puissance et d'isolement dans une cellule de commutation selon l'invention.

Dans cet exemple, et selon une technique connue de l'homme du métier, les drains et sources des transistors sont réalisés sous la forme de doigts interdigités, afin d'augmenter leur rendement.

Tout comme dans la figure 10a, dans la cellule de commutation selon l'invention, les transistors de puissance 1011 et d'isolement 1012 sont réalisés au sein d'un même motif actif comprenant un accès central de grilles 1013, permettant le pilotage des grilles par un même courant de commande, et une source 1014 commune aux deux transistors. Cette source est répartie de part et d'autre de l'accès central de grilles, les parties étant reliées par des ponts de source 1017, qui passent au dessus de cet accès central. La source 1014 présente des doigts interdigités avec les doigts des drains 1015 et 1016 des différents transistors. Les doigts de source sont reliés ensemble par des ponts de source 1019 qui passent au-dessus des doigts de drain.

Le transistor de puissance 1011 comprend également un drain 1015, présentant un accès, et positionné d'un côté de l'accès central de grilles. Ce drain comprend des doigts intercalés avec les doigts de la source 1014 du motif.

Le transistor d'isolement 1012 comprend un autre drain 1016, présentant un accès différent du drain 1015, et positionné de l'autre côté de l'accès central de grilles. Ce drain comprend lui aussi des doigts intercalés avec les doigts de la source 1014 du motif.

Enfin, le motif comprend des doigts de grille 1018, reliés à l'accès central de grille, et qui s'étendent entre les doigts de source 1014 et les doigts de drain 1015 et 1016.

## Revendications

1. Cellule de commutation de puissance comprenant :

    - un port d'entrée apte à recevoir un signal de commande de commutation ($V_{IN}$),
    - un transistor d'entrée ($T_{com}$) ayant une grille reliée audit port d'entrée, et une source reliée à une tension de référence ($V_{SS}$),
    - un circuit d'auto-polarisation (P) comprenant une résistance ($R_{pol}$) et un transistor d'auto-polarisation ($T_{pol}$), une grille dudit transistor d'auto-polarisation étant reliée à un drain dudit transistor d'entrée ($T_{com}$), la résistance ($R_{pol}$) étant connectée en parallèle entre une grille et une source dudit transistor d'auto-polarisation ($T_{pol}$) et en série entre un drain du transistor d'entrée et une source dudit transistor d'auto-polarisation ($T_{pol}$),
    - un transistor de puissance ($T_p$), ayant une grille reliée à une source du transistor d'auto-polarisation ($T_{pol}$), un drain relié à une tension d'alimentation ($V_{DD}$), et une source reliée à un drain du transistor d'auto-polarisation ($T_{pol}$), et
    - un port de sortie,

    la cellule de commutation étant **caractérisée en ce qu'**elle comprend en outre un transistor d'isolement ($T_{iso}$) ayant une grille reliée à une grille du transistor de puissance ($T_p$), une source reliée à une source du transistor de puissance ($T_p$) et un drain relié audit port de sortie de la cellule.

2. Cellule de commutation selon la revendication 1, dans laquelle le transistor de puissance ($T_p$), le transistor d'auto-polarisation ($T_{pol}$) et le transistor d'isolement ($T_{iso}$) sont des transistors à effet de champ de type normalement conducteur.

3. Cellule de commutation selon la revendication 2, dans laquelle les transistors à effet de champ sont des Transistors à Haute Mobilité Electronique, ou HEMT, réalisés dans une technologie choisie dans la liste suivante : Nitrure de Galium, Arséniure de Galium.

4. Cellule de commutation selon l'une des revendications précédentes, dans laquelle le transistor de puissance ($T_p$) et le transistor d'isolement ($T_{iso}$) ont des caractéristiques électriques sensiblement identiques.

5. Cellule de commutation selon l'une des revendications précédentes, dimensionnée de sorte que :

    - la commutation à l'état passant du transistor d'entrée ($T_{com}$), par le signal d'entrée ($V_{IN}$), commande la commutation à l'état bloqué desdits transistors d'auto-polarisation ($T_{pol}$), de puissance ($T_p$) et d'isolement ($T_{iso}$), et

- la commutation à l'état bloqué du transistor d'entrée ($T_{com}$), par le signal d'entrée ($V_{IN}$), commande la commutation à l'état passant desdits transistors d'auto-polarisation ($T_{pol}$), de puissance ($T_p$) et d'isolement ($T_{iso}$).

6. Cellule de commutation selon l'une des revendications précédentes, réalisée en circuit intégré monolithique hyperfréquence, ou technologie MMIC.

7. Cellule de commutation selon la revendication 6, dans laquelle ledit transistor de puissance ($T_p$) et ledit transistor d'isolement ($T_{iso}$) sont implémentés dans un motif unique comprenant un accès central de grilles (1003), une source (1004) répartie de part et d'autre de l'accès central de grilles, un drain (1005) constitutif du transistor de puissance (1001) d'un côté de l'accès central de grilles, et un drain (1006) constitutif du transistor d'isolement (1002) d'un autre côté de l'accès central de grilles.

8. Cellule de commutation selon la revendication 6, dans laquelle ladite source (1014) et lesdits drains (1015 et 1016) sont interdigités.

9. Convertisseur de tension multi-niveaux, **caractérisé en ce qu'**il comprend une pluralité de cellules de commutation ($C_0$, $C_1$, $C_2$, $C_3$) selon l'une des revendications 1 à 8 disposées en parallèle, chacune desdites cellules ayant un port de sortie relié à un même port de sortie dudit convertisseur multi-niveaux, et étant configurée pour fournir une tension de sortie différente de celle des autres cellules de commutation.

10. Système d'amplification d'un signal comprenant un amplificateur de puissance (121) et un convertisseur de tension multi-niveaux (122) selon la revendication 9, ledit convertisseur de tension multi-niveaux étant configuré pour générer une tension de polarisation dynamique dudit amplificateur de puissance.

**Patentansprüche**

1. Leistungsschaltzelle, die Folgendes umfasst:

   - einen Eingangsport, der ein Schaltsteuersignal ($V_{IN}$) empfangen kann.
   - einen Eingangstransistor ($T_{com}$) mit einem mit dem Eingangsport verbundenen Gate und einer mit einer Referenzspannung (Vss) verbundenen Source,
   - eine Selbstvorspannungsschaltung (P), die einen Widerstand ($R_{pol}$) und einen Selbstvorspannungstransistor ($T_{pol}$) umfasst, wobei ein Gate des Selbstvorspannungstransistors mit einem Drain des Eingangstransistors ($T_{com}$) verbunden ist, wobei der Widerstand ($R_{pol}$) parallel zwischen einem Gate und einer Source des Selbstvorspannungstransistors ($T_{pol}$) und in Reihe zwischen einem Drain des Eingangstransistors und einer Source des Selbstvorspannungstransistors ($T_{pol}$) geschaltet ist,
   - einen Leistungstransistor ($T_p$) mit einem mit einer Source des Selbstvorspannungstransistors ($T_{pol}$) verbundenen Gate, einem mit einer Versorgungsspannung ($V_{DD}$) verbundenen Drain und einer mit einem Drain des Selbstvorspannungstransistors ($T_{pol}$) verbundenen Source, und
   - einen Ausgangsport,

   wobei die Schaltzelle **dadurch gekennzeichnet ist, dass** sie ferner einen Isolationstransistor ($T_{iso}$) mit einem mit einem Gate des Leistungstransistors ($T_p$) verbundenen Gate, einer mit einer Source des Leistungstransistors ($T_p$) verbundenen Source und einem mit dem Ausgangsport der Zelle verbundenen Drain umfasst.

2. Schaltzelle nach Anspruch 1, wobei der Leistungstransistor ($T_p$), der Selbstvorspannungstransistor ($T_{pol}$) und der Isolationstransistor ($T_{iso}$) Feldeffekttransistoren des normalerweise leitenden Typs sind.

3. Schaltzelle nach Anspruch 2, wobei die Feldeffekttransistoren HEMTs (High Electronic Mobility Transistors) sind, hergestellt mit einer Technologie, die aus der folgenden Liste ausgewählt ist: Galiumnitrid, Galiumarsenid.

4. Schaltzelle nach einem der vorherigen Ansprüche, wobei der Leistungstransistor ($T_p$) und der Isolationstransistor ($T_{iso}$) im Wesentlichen identische elektrische Eigenschaften aufweisen.

5. Schaltzelle nach einem der vorherigen Ansprüche, so dimensioniert, dass:

   - das Schalten des Eingangstransistors ($T_{com}$) in den Durchlasszustand durch das Eingangssignal ($V_{IN}$) das

Schalten des Selbstvorspannungs- ($T_{pol}$), des Leistungs- ($T_p$) und des Isolationstransistors ($T_{iso}$) in den Sperrzustand bewirkt, und

- das Schalten des Eingangstransistors ($T_{com}$) in den Sperrzustand durch das Eingangssignal ($V_{IN}$) das Schalten des Selbstvorspannungs- ($T_{pol}$), des Leistungs- ($T_p$) und des Isolationstransistors ($T_{iso}$) in den Durchlasszustand bewirkt.

6. Schaltzelle nach einem der vorherigen Ansprüche, hergestellt in monolithischer integrierter Hochfrequenzschaltung oder MMIC-Technologie.

7. Schaltzelle nach Anspruch 6, wobei der Leistungstransistor ($T_p$) und der Isolationstransistor ($T_{iso}$) in einem einzigen Muster implementiert sind, das einen zentralen Gate-Zugang (1003), eine auf beiden Seiten des zentralen Gate-Zugangs verteilte Source (1004), einen den Leistungstransistor (1001) auf einer Seite des zentralen Gate-Zugangs bildenden Drain (1005) und einen den Isolationstransistor (1002) auf einer anderen Seite des zentralen Gate-Zugangs bildenden Drain (1006) umfasst.

8. Schaltzelle nach Anspruch 6, wobei die Source (1014) und die Drains (1015) und 1016) interdigitiert sind.

9. Mehrstufiger Spannungswandler, **dadurch gekennzeichnet, dass** er mehrere parallel angeordnete Schaltzellen ($C_0$, $C_1$, $C_2$, $C_3$) nach einem der Ansprüche 1 bis 8 umfasst, wobei jede der Zellen einen Ausgangsport hat, der mit demselben Ausgangsport des mehrstufigen Wandlers verbunden und zum Liefern einer anderen Ausgangsspannung als die anderen Schaltzellen konfiguriert ist.

10. System zum Verstärken eines Signals, das einen Leistungsverstärker (121) und einen mehrstufigen Spannungswandler (122) nach Anspruch 9 umfasst, wobei der mehrstufige Spannungswandler zum Erzeugen einer dynamischen Vorspannung des Leistungsverstärkers konfiguriert ist.

**Claims**

1. A power switching cell comprising:

   - an input port capable of receiving a switching control signal ($V_{IN}$),
   - an input transistor ($T_{com}$) having a gate linked to said input port, and a source linked to a reference voltage (Vss),
   - a self-biasing circuit (P) comprising a resistor ($R_{pol}$) and a self-biasing transistor ($T_{pol}$), a gate of said self-biasing transistor being linked to a drain of said input transistor ($T_{com}$), the resistor ($R_{pol}$) being connected in parallel between a gate and a source of said self-biasing transistor ($T_{pol}$) and in series between a drain of the input transistor and a source of said self-biasing transistor ($T_{pol}$),
   - a power transistor ($T_p$), having a gate linked to a source of the self-biasing transistor ($T_{pol}$), a drain linked to a power supply voltage ($V_{DD}$), and a source linked to a drain of the self-biasing transistor ($T_{pol}$), and
   - an output port,

   the switching cell being **characterised in that** it further comprises an isolating transistor ($T_{iso}$) having a gate linked to a gate of the power transistor ($T_p$), a source linked to a source of the power transistor ($T_p$) and a drain linked to said output port of the cell.

2. The switching cell according to claim 1, wherein the power transistor ($T_p$), the self-biasing transistor ($T_{pol}$) and the isolating transistor ($T_{iso}$) are field-effect transistors of normally-conducting type.

3. The switching cell according to claim 2, wherein the field-effect transistors are High Electron Mobility Transistors, or HEMT, produced in a technology chosen from the following list: Gallium Nitride, Gallium Arsenide.

4. The switching cell according to one of the preceding claims, wherein the power transistor ($T_p$) and the isolating transistor ($T_{iso}$) have substantially identical electrical characteristics.

5. The switching cell according to one of the preceding claims, dimensioned such that:

   - the switching to the on state of the input transistor ($T_{com}$), by the input signal ($V_{IN}$), commands the switching to the off state of said self-biasing ($T_{pol}$), power ($T_p$) and isolating ($T_{iso}$) transistors, and

- the switching to the off state of the input transistor ($T_{com}$), by the input signal ($V_{IN}$), commands the switching to the on state of said self-biasing ($T_{pol}$), power ($T_p$) and isolating ($T_{iso}$) transistors.

6. The switching cell according to one of the preceding claims, produced in monolithic microwave integrated circuit, or MMIC technology.

7. The switching cell according to claim 6, wherein said power transistor ($T_p$) and said isolating transistor ($T_{iso}$) are implemented in a single pattern comprising a central gate access (1003), a source (1004) distributed on either side of the central gate access, a drain (1005) constitutive of the power transistor (1001) on one side of the central gate access, and a drain (1006) constitutive of the isolating transistor (1002) on another side of the central gate access.

8. The switching cell according to claim 6, wherein said source (1014) and said drains (1015 and 1016) are interdigitated.

9. A multi-level voltage converter, **characterised in that** it comprises a plurality of switching cells ($C_0$, $C_1$, $C_2$, $C_3$) according to one of claims 1 to 8 arranged in parallel, each of said cells having an output port linked to one and the same output port of said multi-level converter, and being configured to supply an output voltage different from that of the other switching cells.

10. A system for amplifying a signal comprising a power amplifier (121) and a multi-level voltage converter (122) according to claim 9, said multi-level voltage converter being configured to generate a dynamic bias voltage for said power amplifier.

Art antérieur

FIG.1a

Art antérieur

FIG.1b

Art antérieur

FIG.1c

Art antérieur

FIG.1d

213 $V3$ — Cellule 3 —▷|— 233

212 $V2$ — Cellule 2 —▷|— 232

220 — Sortie

211 $V1$ — Cellule 1 —▷|— 231

203

202

201

# FIG.2

## Art antérieur

$V_{DD}$

P

$V_{GS\_Tpol}$

$V_{DS\_Tcom}$

$R_{pol}$

$T_P$ | $V_{DS\_Tp}$

$V_{IN}$

$T_{com}$

$T_{pol}$

$V_{GS\_Tcom}$

$V_{DS\_Tp}$

$V_{GS\_Tp}$

$V_{OUT}$

$V_{SS}$

$V_{DS\_Tpol}$

## Art antérieur

# FIG.3

Art antérieur

FIG.4a

FIG.4b

Art antérieur

FIG.5a

FIG.5b

FIG.6

FIG.7

VDD3=40V

Tp3

Vcom3
ON

$C_3$

VDD2=30V

Tp2

Vcom2
OFF

$C_2$

VDD1=20V

Tp1

Vcom1
OFF

$V_{sortie}$

$C_1$

VDD0=10V

Tp0

Vcom0
OFF

$C_0$

FIG.8a

FIG.8b

FIG.9

FIG.10a

FIG.10b

## RÉFÉRENCES CITÉES DANS LA DESCRIPTION

**Documents brevets cités dans la description**

- WO 2015162063 A